Europäisches Patentamt

European Patent Office

Office européen des brevets

(11) Veröffentlichungsnummer: **0 337 190 B1**

(12) **EUROPÄISCHE PATENTSCHRIFT**

(45) Veröffentlichungstag der Patentschrift: **29.09.93**

(21) Anmeldenummer: **89105560.0**

(22) Anmeldetag: **29.03.89**

(51) Int. Cl.⁵: **H03J 3/08**, G01R 33/36

(54) **Anordnung zur Abstimmung eines erdsymmetrischen Resonators.**

(30) Priorität: **11.04.88 DE 3811984**

(43) Veröffentlichungstag der Anmeldung:
**18.10.89 Patentblatt 89/42**

(45) Bekanntmachung des Hinweises auf die
Patenterteilung:
**29.09.93 Patentblatt 93/39**

(84) Benannte Vertragsstaaten:
**DE FR GB**

(56) Entgegenhaltungen:
**FR-A- 811 715
GB-A- 554 542
US-A- 1 987 124
US-A- 4 633 181**

**J. PHYS. E, SCIENT. INSTR., Band 12, Nr. 6,
Juni 1979, Seiten 484-489, The Institute of
Physics; P.M. BUTCHER et al.: "Butterfly oscillators as detectors of nuclear quadrupole
resonance signals"**

(73) Patentinhaber: **SIEMENS AKTIENGESELL-
SCHAFT
Wittelsbacherplatz 2
D-80312 München(DE)**

(72) Erfinder: **Oppelt, Ralph, Dr.
Lindenweg 1
D-8525 Uttenreuth(DE)**

Rank Xerox (UK) Business Services
(3.10/3.6/3.3.1)

**Beschreibung**

Die Erfindung bezieht sich auf eine Anordnung zur Abstimmung eines erdsymmetrischen Resonators mit wenigstens einer Hochfrequenz-Spule, deren Induktivität mit einer Kapazität den Resonator bildet.

Es sind Geräte zum Erzeugen von Schnittbildern eines Untersuchungsobjektes, vorzugsweise eines menschlichen Körpers, mit magnetischer Kernresonanz bekannt. Diese sogenannten Kernspintomographen enthalten einen Grundfeld-Magneten, der die Kernspins im menschlichen Körper ausrichtet, und ferner Gradientenspulen, die ein räumlich unterschiedliches Magnetfeld erzeugen, und schließlich Hochfrequenzspulen zur Anregung der Kernspins und zum Empfang der von den angeregten Kernspins emittierten Signale. Beim Einsatz einer derartigen hochfrequenten Anregungs- und Meßspule wird die Induktivität der Spule zusammen mit einer Kapazität als LC-Resonanzkreis geschaltet, wobei dann die Kondensatoranordnung der gewünschten Frequenz entsprechend abgestimmt wird. Zu diesem Zweck ist eine veränderbare Parallelkapazität sowie eine in der Zuleitung angeordnete Serienkapazität zur Ankopplung des Resonators an einen Hochfrequenzgenerator vorgesehen, der vorzugsweise ein Oszillator mit einem nachgeschalteten Sendeverstärker sein kann. Als veränderbare Kapazitäten können Drehkondensatoren verwendet werden, deren Kapazität durch Elektromotoren gesteuert wird (Magnetic Resonance in Medicine 2 (1985), Seiten 490 bis 494).

Der Resonator wird je nach der Größe des Untersuchungsobjekts, beispielsweise des Patienten, unterschiedlich stark belastet, d.h. bedämpft. Bei der Anpassung des Resonators an die Quelle, deren Wellenwiderstand beispielsweise 50 Ohm betragen kann, erhält man somit Anpaßfrequenzen, die vom Belastungsgrad des Resonators abhängig sind. Die Eigenfrequenz des Resonators muß deshalb so verstimmt werden, daß der durch die unterschiedliche Belastung des Resonators bedingte Frequenzfehler wieder kompensiert wird. Zu diesem Zweck wird nach der Einführung eines Patienten in den Kernspintomographen eine Abstimmung des Resonators dadurch vorgenommen, daß die Serienkapazität zur Lastanpassung und die Parallelkapazität zur Frequenzkorrektur nacheinander solange verstellt werden, bis die erforderliche Abstimmung erreicht ist.

Zur Abstimmung des Resonators kann auch ein Differentialdrehkondensator vorgesehen sein.

Eine bekannte Ausführungsform eines derartigen Kondensators zur Abstimmung eines erdunsymmetrischen (unbalanced) Schwingkreises enthält zwei Stapel ruhender Platten, die in Achsrichtung einer gemeinsamen Rotorwelle nebeneinander angeordnet sind. Mit der Drehung der Welle werden bewegliche Platten zwischen die ruhenden Platten bewegt. Der Abstand der Stapel der ruhenden Platten muß verhältnismäßig groß gewählt werden, damit die Restkapazität zwischen den beiden Kondensatoren klein wird. Diese Restkapazität vermindert den Bereich der Kapazitätsänderung (US-Patentschrift 1 987 124).

Der Erfindung liegt nun die Aufgabe zugrunde, einen erdsymmetrischen (balanced) Resonator mit seiner Anpassung an die Impedanz der Quelle zu verbessern, insbesondere soll die Abhängigkeit des Frequenzfehlers von einer Laständerung so gering werden, daß eine Frequenzkorrektur praktisch überflüssig wird.

Diese Aufgabe wird erfindungsgemäß gelöst mit den kennzeichnenden Merkmalen des Anspruchs 1. In dieser Ausführungsform des Resonanzkreises können die beiden Differentialdrehkondensatoren gemeinsam abgestimmt werden.

Die Differentialdrehkondensatoren können jeweils aus einem Drehkondensator bestehen, dessen Statorplatten um 180° gegeneinander versetzt sind und dessen Rotorplatten aus halben Kreisscheiben bestehen, deren Drehpunkt im Kreismittelpunkt liegt und die mit der Drehachse mechanisch verbunden sind.

Zur weiteren Erläuterung der Erfindung wird auf die Zeichnung Bezug genommen, in deren Figur 1 ein Ausführungsbeispiel einer bekannten Anordnung zur Abstimmung eines Resonators schematisch veranschaulicht ist. Figur 2 zeigt einen Differentialdrehkondensator in einer Seitenansicht und Figur 3 einen Schnitt dieses Differentialdrehkondensators. Ein Ersatzschaltbild ist in Figur 4 schematisch veranschaulicht. Figur 5 zeigt eine Anordnung zur Abstimmung eines erdsymmetrischen Resonators gemäß der Erfindung. Eine bevorzugte Ausführungsform ist in Figur 6 dargestellt. In einem Diagramm gemäß Figur 7 ist der technische Effekt der Erfindung veranschaulicht.

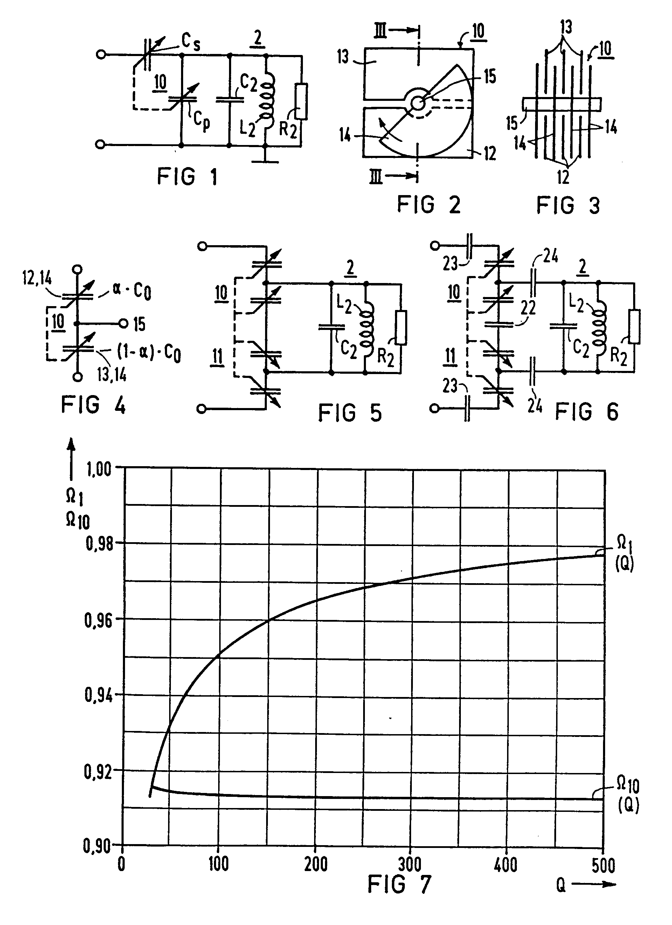

In der bekannten Ausführungsform einer Anordnung zur Abstimmung eines erdunsymmetrischen Resonators gemäß Figur 1 ist eine Hochfrequenzspule $L_2$, beispielsweise die Antenne eines Kernspintomographen, vorgesehen, die mit einer Kapazität $C_2$ einen Resonator 2 bildet. In der Figur sind die Hochfrequenzverluste, die durch den ohmschen Widerstand der Spule selbst und durch die Wechselwirkung der magnetischen und elektrischen Hochfrequenz-Spulenfelder mit dem Körpergewebe eines Patienten sowie durch Abstrahlung entstehen, mit $R_2$ bezeichnet. Zur Abstimmung sind eine veränderbare Parallelkapazität $C_p$ und eine Serienkapazität $C_s$ vorgesehen. Diese Parallelkapazität $C_p$ und die Serienkapazität $C_s$ bilden einen Differentialdrehkondensator 10.

Eine bekannte Ausführungsform eines derartigen Differentialdrehkondensators 10 kann gemäß Figur 2 zwei einander gegenüberliegende Stapel von Statorplatten 12 und 13 enthalten, die mit beweglichen Rotorplatten 14 den Differentialkondensator bilden. Die Rotorplatten 14 sind um eine gemeinsame Drehachse 15 drehbar gelagert.

Diese Rotorplatten 14 sind gemäß dem Schnitt nach Figur 3 an der Drehachse 15 zwischen den Statorplatten 12 und 13 derart angeordnet, daß sie mit der Drehung um die Drehachse 15 jeweils von einer Endstellung in die andere bewegt werden können. Die Platten 12 und 13 sowie die Drehachse 15 sind jeweils mit einem in der Figur nicht dargestellten elektrischen Anschlußleiter versehen.

Zwischen den Platten 12 und 14 sowie 13 und 14 entsteht jeweils ein Kondensator, dessen Kapazität von der Stellung der Rotorplatten 14 abhängig ist.

Mit einem normierten Drehwinkel $\alpha$ erhält man gemäß dem Ersatzschaltbild der Figur 4 einen Differentialdrehkondensator 10, bei dem die Kapazität des einen Kondensators $\alpha.C_0$ und die Kapazität des anderen Kondensators $(1 - \alpha).C_0$ beträgt. In einer Endstellung, in der die Rotorplatten 14 die Statorplatten 12 ganz überlappen, hat somit der zwischen diesen Platten 12 und 14 gebildete Kondensator die Kapazität $C_0$ und die Kapazität des zwischen den anderen Platten 13 und 14 gebildeten Kondensators ist Null. Mit der Bewegung der Rotorplatten 14 nimmt die Kapazität zwischen den Platten 12, 14 ab und entsprechend die Kapazität zwischen den Platten 13, 14 zu, bis in der anderen Endstellung der zwischen den Platten 13, 14 gebildete Kondensator die Kapazität $C_0$ erreicht.

In der Ausführungsform gemäß Figur 5 ist ein erdsymmetrischer Resonator 2 gemäß der Erfindung mit der Induktivität $L_2$ dem Widerstand $R_2$ und der Resonatorkapazität $C_2$ über zwei Differentialdrehkondensatoren 10 und 11 an eine in der Figur nicht dargestellte Energiequelle angeschlossen. Die beiden baugleichen Differentialdrehkondensatoren 10 und 11 sind mechanisch derart gekoppelt, daß man eine entsprechend gegenläufige Änderung der Kapazitäten zum Abstimmen des erdsymmetrischen Resonators 2 erhält.

Die beiden Differentialdrehkondensatoren 10 und 11 gemäß Figur 5 können auch jeweils mit einem elektrischen Antrieb versehen sein. Diese beiden Antriebe sind dann derart elektrisch gekoppelt, daß sich die Kapazitäten in erdsymmetrischer Weise ändern.

In einer weiteren Ausführungsform kann auch eine Kombination von Kondensatoren vorgesehen sein, bei denen wenigstens zum Teil die Kapazität veränderbar ist. Diese Kondensatoren werden dann derart angesteuert, daß ihre Kapazitätsänderung zwei gekoppelte Differentialdrehkondensatoren simuliert. Hierbei kann die Kopplung der Kondensatoren mechanisch ausgeführt sein oder auch wieder durch entsprechende Ansteuerung bewirkt werden.

Mit der Ausführungsform gemäß Figur 6 erhält man eine weitere Verminderung der Frequenzabhängigkeit dadurch, daß zwischen den beiden Differentialdrehkondensatoren 10 und 11 ein weiterer Kondensator 22 eingefügt wird. Eine zusätzliche Verminderung der Frequenzabhängigkeit erhält man durch jeweils einen Kondensator 23 in den beiden Zuleitungen. Außerdem kann man die Frequenzabhängigkeit nochmals vermindern durch die Anordnung von zusätzlichen Kondensatoren 24 zwischen den Differentialdrehkondensatoren 10 und 11 und dem Resonator 2. Unter Umständen erhält man ein Minimum der Frequenzabhängigkeit auch dadurch, daß anstelle des Kondensators 22 nur die Kondensatoren 23 oder nur die Kondensatoren 24 eingesetzt werden. Ferner können sowohl die Kondensatoren 23 als auch die Kondensatoren 24 eingesetzt werden. Es kann ferner auch nur eine der Gruppen von Kondensatoren 23 und 24 mit dem Kondensator 22 eingesetzt werden.

Im Diagramm gemäß Figur 7 ist die normierte Kreisfrequenz $\Omega$ in Abhängigkeit von der Güte Q des Schwingkreises veranschaulicht. Würde in einer Ausführungsform gemäß dem Stand der Technik mit nur einer Serienkapazität $C_S$ und ohne Parallelkapazität $C_p$, d.h. mit $C_p = 0$, nur die Serienkapazität $C_S$ an die jeweilige Last angepaßt, so ergibt sich gemäß Figur 1 die auf

$$1/\sqrt{L_2 . C_2}$$

normierte Anpaßfrequenz $\Omega_1$ als Funktion der Güte Q:

$$\Omega_1(Q) = \sqrt{\Delta - \sqrt{\Delta^2 - 1}}$$

3

mit

$$\Delta = 1 + \frac{z_K}{2Q} - \frac{1}{2Q^2}$$

Darin ist

$$Q = \frac{R_2}{\sqrt{L_2/C_2}},$$

die Güte und

$$z_K = \frac{\sqrt{L_2/C_2}}{Z}$$

die auf die Quellimpedanz $Z$ normierte Schwingkreiskennimpedanz.

Die niedrigste Güte $Q$, bei der noch Anpassung möglich ist, wird durch den Maximalwert der Serienkapazität $C_S$ festgelegt.

Gemäß dem Diagramm der Figur 7 ändert sich im Bereich von $50 \leq Q \leq 500$ die normierte Anpaßfrequenz $\Omega_1$ um ca. 4,5 %.

Dagegen erhält man mit einem dem Resonator 2 zugeordneten Differentialdrehkondensator 10 eine normierte Anpaßfrequenz $\Omega_{10}$ als Funktion der Güte $Q$:

$$\Omega_{10}(Q) = \frac{1 + \sqrt{4Q^2(1+c_0)(Qz_K-1)+1}}{2\,Q\sqrt{Qz_K-1}\,(1+c_0)} ,$$

wobei $C_0 = C_0/C_2$ das Kapazitätsverhältnis von $C_0$ zu $C_2$ ist. Die niedrigste Güte, bei der noch Anpassung möglich ist, wird durch die Bedingung $\alpha \leq 1$ gegeben. Für ein berechnetes $Q_{10}(Q)$ ist also zu prüfen, ob

$$c_0\Omega_{10}(Q)[\tfrac{1}{Q}, \sqrt{Qz_K-1} - \Omega_{10}(Q)] \geq 1$$

noch gilt. Aus dem Verlauf der Funktion $\Omega_{10}(Q)$ kann man entnehmen, daß sich mit zunehmender Güte $Q$ für $\Omega_{10}$ der Grenzwert $(1 + c_0)^{-1/2}$ einstellt. Das Diagramm gemäß Figur 7 zeigt den wesentlich flacheren Verlauf der Funktion $\Omega_{10}(Q)$ im Vergleich zu $\Omega_1(Q)$. Dabei wurde $c_0$ zu 0,2 angenommen und wieder die normierte Schwingkreiskennimpedanz $z_K = 1$ gewählt. Im dargestellten Bereich von $50 \leq Q \leq 500$ ändert sich die normierte Anpaßfrequenz $\Omega_{10}$ nur noch um etwa 0,1 %.

**Patentansprüche**

1. Anordnung zur Abstimmung eines erdsymmetrischen Resonators (L2,C2) mit wenigstens einer Hochfrequenzspule, deren Induktivität mit einer Kapazität den Resonator bildet, **dadurch gekennzeichnet,** daß zur Abstimmung zwei gleiche Differentialdrehkondensatoren (10, 11) vorgesehen sind, die so gesteuert werden, daß sich mit der Drehung ihre Kapazitäten in erdsymmetrischer Weise ändern.

2. Anordnung nach Anspruch 1, **dadurch gekennzeichnet,** daß die Differentialdrehkondensatoren (10, 11), jeweils aus einem Drehkondensator bestehen, der zwei Stapel von Statorplatten (12, 13) enthält,

4

die senkrecht zur Drehachse angeordnet sind und an der Drehachse (15) einander gegenüberliegen und der ferner einen gemeinsamen Stapel von Rotorplatten (14) in der Form einer halben Kreisscheibe mit ihrem Drehpunkt im Kreismittelpunkt enthält, der mit der Drehachse (15) mechanisch verbunden ist.

3. Anordnung nach Anspruch 1, **dadurch gekennzeichnet,** daß zwischen den Differentialdrehkondensatoren(10, 11) ein Kondensator (22) angeordnet ist.

4. Anordnung nach Anspruch 1, **dadurch gekennzeichnet,** daß in den Zuleitungen zu den Differentialdrehkondensatoren (10, 11) jeweils ein Kondensator (23) angeordnet ist.

5. Anordnung nach Anspruch 1, **dadurch gekennzeichnet,** daß in den Verbindungsleitungen zwischen den Differentialdrehkondensatoren (10, 11) und dem Resonator (2) jeweils ein Kondensator (24) angeordnet ist.

6. Anordnung nach Anspruch 1, **gekennzeichnet** durch eine Kombination von Kondensatoren mit veränderbarer Kapazität, die derart gesteuert werden, daß ihre Kapazitätsänderung zwei gekoppelte Differentialdrehkondensatoren simuliert.

## Claims

1. Arrangement for tuning a balanced-to-earth resonator (L2, C2) having at least one high-frequency coil, the inductance of which, with a capacitor, forms the resonator, characterised in that, for tuning, there are provided two identical differential rotary capacitors (10, 11) which are controlled in such a way that, with rotation, their capacitances change in a balanced-to-earth manner.

2. Arrangement according to claim 1, characterised in that the differential rotary capacitors (10, 11) consist respectively of a rotary capacitor, which comprises two stacks of stator plates (12, 13) which are arranged perpendicularly to the rotational axis and are located opposite each other on the rotational axis (15), and which rotary capacitor further comprises a common stack of rotor plates (14) in the form of a semi-circular disc having its centre of rotation at the centre of the circle, which stack is mechanically connected to the rotational axis (15).

3. Arrangement according to claim 1, characterised in that a capacitor (22) is arranged between the differential rotary capacitors (10, 11).

4. Arrangement according to claim 1, characterised in that a capacitor (23) is arranged respectively in the feed lines to the differential rotary capacitors (10, 11).

5. Arrangement according to claim 1, characterised in that a capacitor (24) is arranged respectively in the connecting lines between the differential rotary capacitors (10, 11) and the resonator (2).

6. Arrangement according to claim 1, characterised by a combination of capacitors having a variable capacitance, which capacitors are controlled in such a way that the change in their capacitance simulates two coupled differential rotary capacitors.

## Revendications

1. Dispositif pour accorder un résonateur (L2,C2) symétrique par rapport à la terre et comportant au moins une bobine à haute fréquence dont l'inductance forme avec une capacité le résonateur, caractérisé par le fait que pour l'accord, il est prévu deux condensateurs rotatifs différentiels identiques (10,11), qui sont commandés de telle sorte que lors de la rotation, leurs capacités varient d'une manière symétrique par rapport à la terre.

2. Dispositif suivant la revendication 1, caractérisé par le fait que les condensateurs rotatifs différentiels (10,11) sont constitués chacun par un condensateur rotatif qui comporte deux piles de plaques statoriques (12,13), qui sont disposées perpendiculairement à l'axe de rotation et qui sont situées vis-à-vis l'une de l'autre à proximité de l'axe de rotation (15), et qui en outre comporte une pile commune de plaques rotoriques (14) possédant la forme d'un disque semi-circulaire dont le centre de rotation coïncide avec le centre du cercle, qui est raccordé mécaniquement à l'axe de rotation (15).

3. Dispositif suivant la revendication 1, caractérisé par le fait qu'un condensateur (22) est disposé entre les condensateurs rotatifs différentiels (10,11).

4. Dispositif suivant la revendication 1, caractérisé par le fait qu'un condensateur (23) est disposé respectivement dans les conducteurs d'alimentation aboutissant aux condensateurs rotatifs différentiels (10,11).

5. Dispositif suivant la revendication 1, caractérisé par le fait qu'un condensateur (24) est disposé dans chacun des conducteurs de liaison entre les condensateurs rotatifs différentiels (10,11) et le résonateur (2).

6. Dispositif suivant la revendication 1, caractérisé par une combinaison de condensateurs à capacités variables, et qui sont commandés de telle manière que la variation de leur capacité simule deux condensateurs rotatifs différentiels accouplés.

FIG 1

FIG 2

FIG 3

FIG 4

FIG 5

FIG 6

FIG 7